# EUROPEAN PATENT APPLICATION

(11) **EP 1 310 990 A1**
(43) Date of publication of application: **14.05.2003**
(21) Application number: 01811081.7
(22) Date of filing: 09.11.2001
(51) Int. Cl.: H01L 21/56, H01L 21/58, H01L 21/60

(54) **Bonding method with improved alignment**

(71) Applicant: ABB RESEARCH LTD., 8050 Zürich (CH)
(72) Inventor: Knapp, Wolfgang, 5430 Wettingen (CH); Thoma, Marco, 5200 Brugg (CH)
(74) Representative: ABB Patent Attorneys

(57) **Abstract**

In a method for assembling components, in particular for packaging of electronic components, in which at least a first component, in particular a semiconductor die (10), and a second component, in particular a substrate (30) are fixed onto one another in a bonding step. Relative alignment between the first and second component is established before and maintained during the bonding step by inserting the first and second component into an indentation (201) of a preform (20). The preform is then closed, thus forming an encapsulation (2), which is sealed prior to the bonding step.

## Description

### Technical Field

The invention relates to the field of bonding methods. It relates to a method for component assembly, in particular in electronic packaging as claimed in the precharacterizing clause of claim 1.

### Prior Art

Low temperature bonding is a method for fixing a semiconductor die to a substrate. When producing, for example, bipolar semiconductor products like round wafer diodes or gate turn-off transistors for high-power applications, the semiconductor die - in this case a silicon wafer - in which the device was formed is joined to the substrate, e.g. a molybdenum disc.

Bonding is achieved by placing the semiconductor die on top of the substrate with a sintering layer in between. The sintering layer is a metallic powder, e.g. silver powder. It is applied to either a contact surface of the semiconductor die or of the substrate or both. By heating and applying forces that press the semiconductor die against the substrate and the other way round, the semiconductor die and the substrate will sinter together with the sintering layer. This way, the semiconductor die is fixed to the substrate by means of a rigid and permanent material connection. Typical process parameters are pressures of between 1000N/cm² and 7000N/cm² and temperatures of between 150°C and 300°C that are applied for a few seconds to a few minutes.

One challenge that is difficult to address is a relative alignment between the die and the substrate prior to bonding. Especially for chip type power semiconductors like field effect transistors or insulated gate bipolar transistors, gate contacting sets tight tolerances in the range of ±50µm. An additional difficulty is posed by the fact that once a sufficiently accurate alignment is established, this alignment has to be maintained during any subsequent process steps, e.g. during handling and the actual bonding step.

Currently, two methods are known that permit a sufficiently accurate alignment of the semiconductor die to be maintained, namely a prefixation either by means of silicone adhesive or by a local application of pressure and heat to the semiconductor die (at least 200N at 230°C for 15s), which causes a local presintering that will hold the semiconductor die in place during subsequent process steps. Both methods require additional processing steps besides alignment and bonding. Careful and accurate handling of the semiconductor die and the substrate is required during the prefixation, thus limiting the number of dies that can be bonded in a given period of time. In addition, the local application of pressure used in the second method may cause damage to the die as a result of bending forces. Furthermore, prefixation may have negative influence on the quality and homogeneity of a final bond.

### Description of the Invention

It is an objective of the invention presented herein to provide a method of the type mentioned initially that permits an accurate alignment of components to be established and to be maintained during a bonding step and any subsequent process steps, without the necessity of a prefixation to be carried out prior to the bonding step.

This object is achieved by the method as claimed in claim 1. Thus, according to the invention, the first and second component to be assembled are inserted into a preform with their relative positions predetermined by one or several means for alignment that the preform comprises. After that, the preform is closed so that it forms an encapsulation that is subsequently sealed. This way, a large number of first and second components can be assembled in short time while accurate alignment is ensured and maintained.

In a preferred realization, the means for alignment comprises an indentation that is provided in the preform. The first and second component to be assembled are inserted into said indentation of the preform.

In a preferred realization, the indentation of the preform comprises at least a first partial indentation and a second partial indentation. Prior to the bonding step, the first component is inserted into the second partial indentation and the second component is inserted into the first partial indentation.

In a preferred realization, the encapsulation is evacuated prior to being sealed. As a consequence, the components will be pressed together with a difference between a first pressure inside of the encapsulation and a second pressure outside of the encapsulation, e.g. atmospheric pressure.

Further advantageous realizations can be found in the dependent claims.

### Brief Explanation of the Figures

The invention will be explained in more detail in the following text with reference to exemplary realizations and in conjunction with the figures, in which:
Figure 1 shows a schematic representation of steps carried out prior to a bonding step in a possible realization of the method according to the invention;
Figure 2 shows an encapsulation used in a possible realization of the method according to the invention;
Figure 3 shows a schematic representation of steps carried out prior to a bonding step in an alternative realization of the method according to the invention.

The reference signs used in the figures are explained in the list of reference signs.

### Approaches to Realization of the Invention

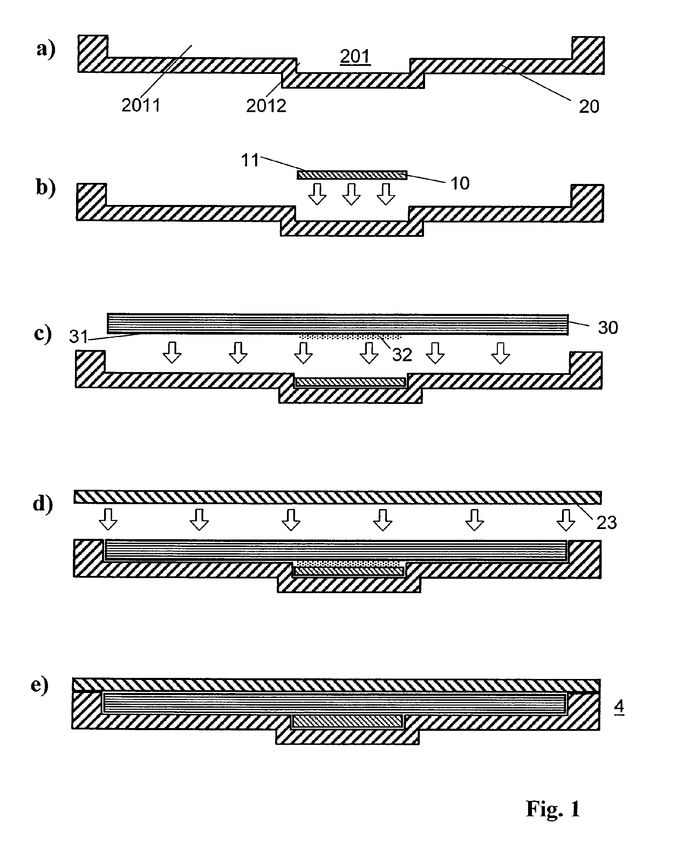

Fig. 1 shows a schematic representation of steps carried out prior to a bonding step in a possible realization of the method according to the invention. A preform 20 features an indentation 201, which comprises a first partial indentation 2011 and a second partial indentation 2012 on a bottom of the first partial indentation 2011. In a first step as shown in Fig. 1b), a semiconductor die 10 is inserted into the second partial indentation 2012 of the preform 20 with a first bond surface 11 of the semiconductor die 10 facing away from the preform 20, i.e. upwards. In a second step as in Fig. 1c), a substrate 30 is inserted into the first partial indentation 2011 of the preform 20 with a second bond surface 31 facing the first bond surface 11 of the semiconductor die 10. A sintering layer 32 which comprises a paste produced from ground silver and paraffin is provided on the second contact surface 31 of the substrate 30.

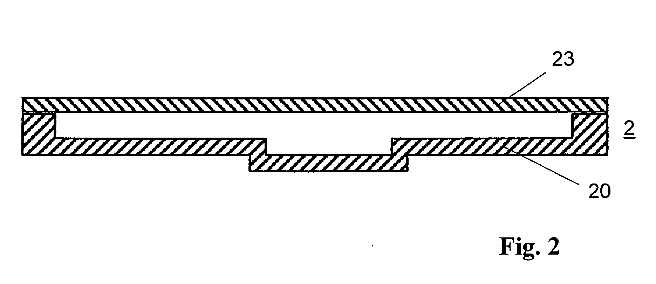

The preform 20 is then closed by a cover 23 that is placed on the top of the preform 20 as shown in Fig. 1d), thus forming an encapsulation 2 which is shown in Fig. 2. Finally, the encapsulation 2 is sealed, preferably gas tight, e.g. by means of hot sealing. Alternatively, adhesive sealing, mechanical clamping, or similar sealing methods can also be used with advantage. Preferably, first dimensions of the first partial indentation 2011 and the second partial indentation 2012 match second dimensions of the semiconductor die 10 and the substrate 30, so that the semiconductor die 10 and the substrate 30 will be held in place relative to one another by the encapsulation 2. In this manner a relative alignment of the semiconductor die 10 and the substrate 30 is established. This alignment will be kept up during subsequent handling and processing of a packet 4 consisting of semiconductor die 10, substrate 30 and encapsulation 2 as shown in Fig. 1e), in particular during a subsequent bonding step.

Once the encapsulation 2 is sealed, the packet 4 can be subdued to the actual bonding step in which the semiconductor die 10 and the substrate 30 are fixed onto one another by sintering the sintering layer 32 together with the semiconductor die 10 and the substrate 30.

In a preferred realization of the invention, the bonding step is triggered and/or accelerated by exposing the packet 4 to heat and/or by inserting it into a pressurized environment, e.g. into a pressure chamber of a fluid press or into a hot-press. As a major advantage when used in combination with bonding in a fluid press, the method according to the invention adds negligible extra cost, since an encapsulation is needed anyway.

In a preferred realization of the invention, the encapsulation 2 is evacuated after the cover 23 has been placed on top of the preform 20 and before the encapsulation 2 is sealed. This permits to efficiently extract moisture that may have remained or may have built up inside of the encapsulation 2. Preferably, a fore-pump is used for evacuating the encapsulation 2, resulting in a residual pressure of between 10mbar and 50mbar inside the encapsulation 2. However, simple household pumps that are able to establish a pressure difference of several 10mbar to several 100mbar between the inside and the outside of the encapsulation 2 can also be used to advantage, particularly in regard of the fact that they are cheap and easy to handle and maintain. In this realization, sealing of the encapsulation is advantageously achieved by suction, i.e. the difference in pressure will force the preform 20 and the cover 23 against one another. In a preferred realization, the substrate 30 acts as a cover for the preform 20.

Preferably, the preform 20 and/or the cover 23 consist of a material that may be deformed in an essentially elastic manner. Alternatively, an plastically deformable material or a material that exhibits both elastic and plastic behaviour when being deformed may also be used to advantage. If the encapsulation 2 is evacuated prior to being sealed, the difference in pressure between the inside and the outside of the encapsulation 2 results in additional forces that press the semiconductor die 10 and the substrate 30 together, leading to an even more stable alignment. The packet 4 is further stabilized and can easily be handled and stored without degradation. In addition, any pressure applied in a subsequent bonding step will be transferred equally from outside of the encapsulation 2 to its inside. Preferably, a thickness of the preform 20 and/or the cover 23 is adjusted according to their material properties. Preferably, the encapsulation 2 is able to withstand temperature, pressure and chemical environment during the bonding step. PTFE and PET may be used to advantage, but other materials may as well be used.

In another preferred realization of the invention, a gas or a mixture of gases is introduced into the encapsulation 2 before the encapsulation 2 is sealed. This permits to accurately control a chemical environment within the encapsulation 2 during the subsequent bonding step. If chemical reactions take place during the bonding step, these reactions can be influenced by an amount and/or composition of gases enclosed in the encapsulation 2. The bonding step may thus be accelerated and unwanted side effects like oxidation of the bonding surfaces may be suppressed.

The preform 20 may be produced by means of vacuum drawing, punching, preforming e.g. of foil or by similar methods. If foil is drawn over or punched by a positive pre-preform which has a shape that matches that of an assembled combination of semiconductor die 10, sintering layer 32 and substrate 30, a foil thickness can be varied without affecting the alignment precision. If production of the preform 20 is done at elevated temperatures, a linear cooling shrinkage can be addressed with an oversized pre-preform. Preferably, a material that can be recycled is used to produce the preform 20 and/or the cover 23.

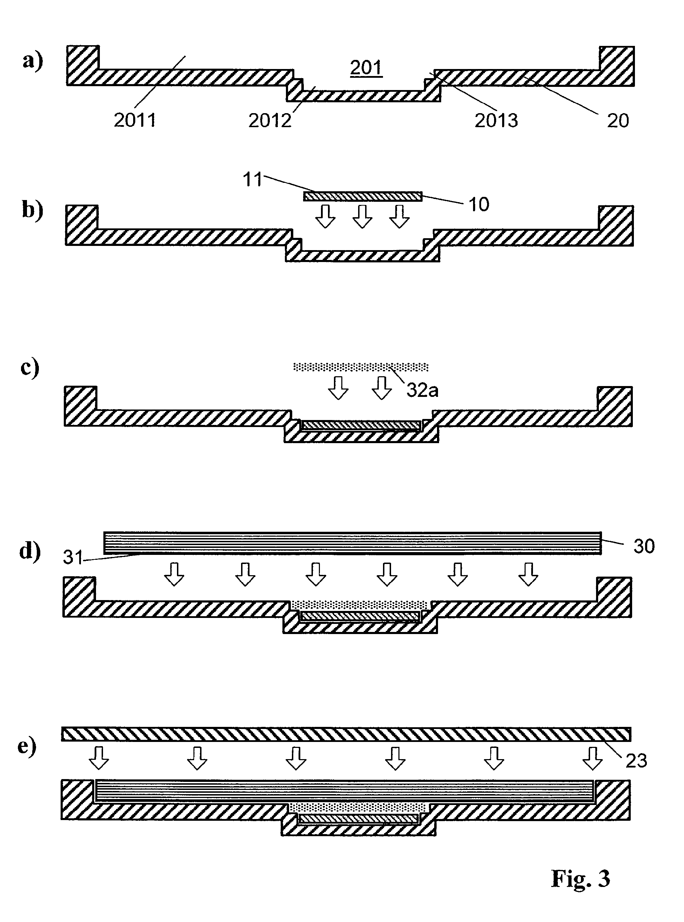

Although described only for bonding a semiconductor die to a substrate, the method according to the invention may be applied to advantage for assembling various other components consisting of a variety of different materials. For example, a first component consisting of glass, ceramic or synthetic materials, metal or semiconductor material may be fixed to a second component consisting of any of the materials just mentioned. Instead of a sintering layer 32, an alternative bonding material 32a, e.g. an adhesive material or a solder may be placed between the first and second component. Preferably, the bonding material 32a is brought into an essentially solid state before being placed between the first and second component. This allows for easier handling of the bonding material. Preferably, as shown in Fig. 3, the indentation 201 comprises a third partial indentation 2013 in which the bonding material is placed. This permits an accurate alignment of the bonding material 32a.

Alternatively, the first and second component may be brought into direct contact. The bonding step may comprise a chemical and/or physical reaction between the respective materials that the first and second components and/or the bonding material may comprise.

In addition, one or more third components may be fixed onto either the first component, the second component or onto one another. Relative alignment between the first, second and third components can advantageously be achieved by inserting the one or more third components into either the first, second or third partial indentation, or into additional partial indentations that the indentation of the preform may comprise.

### List of Reference Signs

- 10: Semiconductor die
- 11: First bond surface
- 2: Encapsulation
- 20: Preform
- 201: Indentation
- 2011: First partial indentation
- 2012: Second partial indentation
- 2013: Third partial indentation
- 23: Cover
- 30: Substrate
- 31: Second bond surface
- 32: Sintering layer
- 32a: Alternative bonding material
- 4: Packet

## Claims

1. A method for assembling components, in particular for packaging of electronic components,
- in which at least a first component, in particular a semiconductor die (10), and a second component, in particular a substrate (30), are fixed onto one another in a bonding step,
**characterized in that** before the bonding step,
- the first and the second component are inserted into a preform with their relative positions predetermined by one or several means for alignment that the preform comprises and that
- the preform is closed, thus forming an encapsulation, and sealed.

2. The method as claimed in the preceding claim, **characterized in that**,
- the one or several means for alignment comprises or comprise an indentation (201) provided in the preform (20),
- the first component and the second component are inserted into the indentation (201).

3. The method as claimed in one of the preceding claims, **characterized in that**
- the indentation (201) comprises at least a first partial indentation (2011) and a second partial indentation (2012) and that
- the first component is inserted into the second partial indentation (2012)
- the second component is inserted into the first partial indentation (2011).

4. The method as claimed in claim 3, **characterized in that**
- the second partial indentation (2012) is located at a bottom of the first partial indentation (2011) and that
- the first component is inserted into the second partial indentation (2012) with a first bond surface (11) facing away from the preform (20) and that afterwards
- the second component is inserted into the first partial indentation (2011) with a second bond surface (31) facing the first component.

5. The method as claimed in one of the preceding claims, **characterized in that**
- a bonding material, in particular a sintering layer (32), is placed between the first component and the second component.

6. The method as claimed in claim 5, **characterized in that**
- the bonding material (32a) is brought into an essentially solid state before it is placed between the first component and the second component.

7. The method as claimed in claim 5 or claim 6, **characterized in that**
- the preform (20) comprises a third partial indentation (2013) and that
- the bonding material (32a) is inserted into the third partial indentation.

8. The method as claimed in one of the preceding claims, **characterized in that**
- the encapsulation (2) is evacuated before being sealed.

9. The method as claimed in one of the preceding claims, **characterized in that**
- a preform (20) consisting of an essentially elastically deformable material is used.

10. The method as claimed in one of the preceding claims, **characterized in that**
- a preform (20) consisting of a plastically deformable material is used.

11. The method as claimed in one of the preceding claims, **characterized in that**
- the encapsulation (2) is filled with a gas or a mixture of gases prior to being sealed.

12. The method as claimed in one of the preceding claims, **characterized in that**
- the preform (20) comprising the indentation (201) is essentially shell shaped and
- is closed by placing an essentially flat cover (23) on top of it.

13. The method as claimed in one of the claims 1 through 11, **characterized in that**
- the preform (20) is closed by inserting the second component into the indentation (201) of the preform.

14. The method as claimed in one of the preceding claims, **characterized in that**
- the first and the second component are fixed onto one another by means of low temperature bonding.

15. The method as claimed in one of the preceding claims, **characterized in that**
- the first and the second component are fixed onto one under application of pressure to the encapsulation (2).

16. The method as claimed in claim 15, **characterized in that**
- pressure is applied in a fluid press.
